Europäisches Patentamt

European Patent Office

Office européen des brevets

(11) Publication number: **0 139 102**
**B1**

(12) EUROPEAN PATENT SPECIFICATION

(45) Date of publication of patent specification: **04.04.90**

(51) Int. Cl.⁵: **G 01 R 33/42**

(21) Application number: **84108349.6**

(22) Date of filing: **16.07.84**

(54) Nuclear magnetic resonance imaging system.

(30) Priority: **15.07.83 US 514169**

(43) Date of publication of application:
**02.05.85 Bulletin 85/18**

(45) Publication of the grant of the patent:
**04.04.90 Bulletin 90/14**

(84) Designated Contracting States:
**DE FR GB IT**

(56) References cited:
**EP-A-0 042 254**
**EP-A-0 067 933**
**FR-A-2 365 123**

**HANDBUCH FüR HOCHFREQUENZ- UND
ELEKTROTECHNIKER, vol. 1, pages 264-265,
Editor : Curt RINT, 12. Auflage**

**The file contains technical information
submitted after the application was filed and
not included in this specification**

(73) Proprietor: **Henry Ford Hospital
2799 West Grand Boulevard
Detroit Michigan 48202 (US)**

(72) Inventor: **Ewing, James R.
5084 Lodewyck
Detroit, Michigan 48224 (US)**

(74) Representative: **Blumbach Weser Bergen
Kramer Zwirner Hoffmann Patentanwälte
Sonnenberger Strasse 100
D-6200 Wiesbaden 1 (DE)**

Courier Press, Leamington Spa, England.

## Description

This invention relates to a nuclear magnetic resonance imaging system according to the preamble of claim 1.

In a known system of that kind described in EP—A—0,067,933, a magnet is disclosed having an outer cylindrical shell of soft iron to support the coils and to close the magnetic circuit. Such a magnet still has a fringing field that can extend beyond the walls of the room where the NMR system is installed.

In order to confine the fringing field within the room where the NMR system is installed, it is possible to shield the walls of the building with appropriate shielding panels. However, such shielding panels have a retroaction into the magnetic field within the magnet. So generally it is necessary to add further shimming coils to counteract the adverse effect of the shielding panels.

The invention solves the problem to confine the magnetic field of the NMR system within a space on the order of a building room without affecting the field within the analysing opening of the magnet to any great extent, that is the uniformity of the high field in the center of the magnet is still preserved.

According to the invention, the system further comprises a substantially continuous cylindrical shell made of second ferromagnetic material and having a length substantially greater than the length of the magnet, a wall thickness sufficient to bring the radially outwardly fringing field external to the shell to less than a predetermined harmless value and a radius substantially greater than the diameter of the magnet and on the order of the dimensions of a storey containing a room which has a top wall, side walls and a floor, said second ferromagnetic material being placed at the point where permeability is substantially at a maximum for the imposed field so as to define said radius and said wall thickness.

This shell has the additional effect of screening out the perturbing effects of large masses of magnetic material which could be present in the walls surrounding the magnet of the NMR system.

An embodiment of the invention is described in conjunction with the drawings, wherein

Fig. 1 is a sectional side elevation of view of a NMR system embodying the invention, and

Fig. 2 is an end view of the system taken along the line 2—2 in Fig. 1.

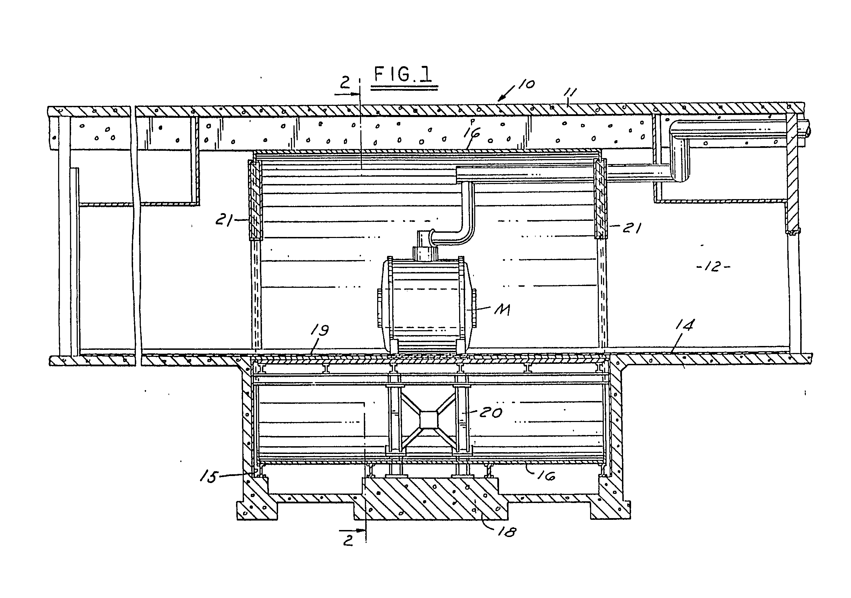

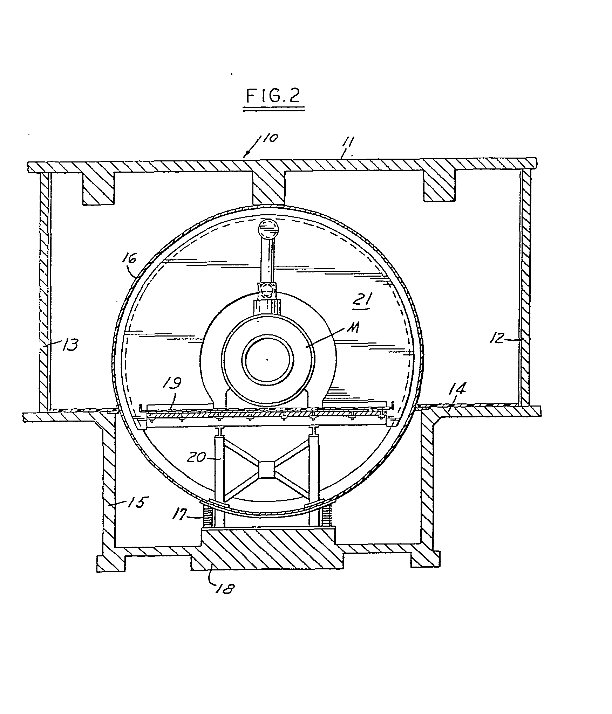

Referring to Figs. 1 and 2, the invention is shown in connection with an NMR system and preferably includes a room 10 having a top wall 11, side walls 12, 13, and a floor 14, a pit or excavation 15 is provided in the floor, and a cylinder 16 that forms the shield for the system is supported by stanchion 17 on a foundation 18 within the pit so that a portion of the cylinder is below floor level but the center of the cylinder is above floor level. A floor 19 of non-magnetic material such as aluminum is supported by a frame network 20 so that the level of the floor 19 is at the same as the level of the floor 14 of the room.

The nuclear magnetic resonance magnet M is supported on the non-magnetic floor 19 with its axis concentric with the axis of the shield 16, preferably within one-half centimeter. The imaging system includes a conventional radio-frequency (RF) coil and a receiver coil as is well known in the art. The magnet M is preferably of the super cooled variety which will produce magnetic fields on the order of 1 to 2 T (10 to 20 kilogauss).

The shell or shield 16 is made of a magnetic material preferably annealed cold rolled steel that may be made of several pieces welded to form a continuous cylindrical body, the end of which are open. In use, end walls 21 are provided and made of a heat insulating material such as gypsum board in the form of an annular wall leaving the ends open for movement of a subject or patient on a stretcher or other device within the magnet.

The diameter of the shield 16 is such that the material of the shield is positioned radially outwardly about the magnet at a point where the permeability of the shield under the influence of the magnetic field of the magnet is a maximum or peak. The thickness of the shield is such that there is sufficient magnetic material to bring fields external to the shell to less than $8 \cdot 10^{-4}$ T (8 gauss).

The use of the shield and the positioning of the field has the effect of shielding the area beyond the shield so that the environment is not adversely affected and electrical devices such as pacemakers are not adversely affected.

Although the applicant does not wish to be bound by the theory involved, it is believed that the use of the cylindrical shell as a shield in the field of the magnet provides a countermagnetic field that functions to minimize any tendency of the main magnetic field at the magnet to extend to any great extent beyond the diameter of the shell. The shield has the effect of cancelling major components of the field due to the central source, namely, the magnetic field outside of the shield. The effect of the shield on the central field of the magnet is uniform and minimal. Thus, the shielding effect of the shell is one of an induced countervailing magnetic field which has its greatest relative effect external to the shield.

In a typical installation, a solenoidal magnet comprises three current rings spaced along their common axis. The central ring has a radius of 52.5 cm and is 15 cm long. It carries $0.5 \times 10^6$ amp turns. The two outer rings have a radius of 41.25 cm and start from the centerline of the central ring at 25.5 cm, ending at 57 cm. Each of these two rings placed equal distance from the center of the central ring carries $0.5 \times 10^6$ amp turns of current.

It is desired to reduce the peak fringing field at 3.6 meters to less than $8 \cdot 10^{-4}$ T (8 gauss). The peak unshielded field at 3.6 meters is $4.4 \times 10^{-3}$ T (44 gauss).

A shell is 6.0959 m (20 feet) long and 2.7431 m (9 feet) in radius 25.4 mm (one inch) thick, of annealed mild steel. The maximum carbon content of the material is 0.01 percent.

In order to prevent a large force on the central magnet, the concentricity of the shield and magnet should be preserved to within 5 cm. The coangularity of the cylinder and magnet must be preserved to within 3 degrees. The cylindricality of the shield must be to within + or −1/2 cm.

## Claims

1. A nuclear magnetic resonance imaging system comprising:
   a high field solenoid magnet (M) providing a uniform static magnetic field and having both ends open to define a test opening into which a human subject can be positioned,
   a RF coil surrounding the test opening,
   a receiver coil surrounding the test opening and
   first ferromagnetic material surrounding the magnet the RF and receiver coils for shielding the magnetic field,
   characterized in that said system further comprises:
   —a substantially continuous cylindrical shell (16) made of second ferromagnetic material and having
   —a length substantially greater than the length of the magnet (M),
   —a wall thickness sufficient to bring the radially outwardly fringing field external to the shell (16) to less than a predetermined harmless value and
   —a radius substantially greater than the diameter of the magnet and on the order of the dimensions of a storey containing a room which has a top wall (11), side walls (12, 13) and a floor (14), said second ferromagnetic material being placed at the point where permeability is substantially at a maximum for the imposed field so as to define said radius and said wall thickness.

2. The NMR system set forth in claim 1 wherein said predetermined value is less than $8 \times 10^{-4}$ Tesla (8 Gauss).

3. The NMR system set forth in claim 1 or 2 wherein said shell (16) is made of annealed cold rolled steel.

4. The NMR system set forth in any of claims 1 to 3 wherein said room (11 to 14) has a non-magnetic floor portion (19) which is arranged within said shell (16) and externally to said magnet (M).

5. The NMR system according to claim 4, wherein said room (11 to 14) has a pit (15) in its floor (14) and said floor portion (19) is coplanar with the room floor (14).

6. The NMR system according to any one of the claims 1 to 5, wherein the concentricity of the shell (16) and the magnet (M) is within 5 cm and the coangularity of the cylinder and the magnet is within 3 degrees.

7. The NMR system according to any one of the claims 1 to 6, wherein the RF and receiver coils are concentric within 0.5 cm.

8. The NMR system according to one of the claims 1 to 7, further including a non-magnetic support movable axially into and out of the magnet (M) for supporting a subject to be examined.

9. The NMR system according to one of the claims 1 to 8, wherein said shell (16) and said magnet (M) are concentric within 0.5 cm.

## Patentansprüche

1. NMA-Abbildungssystem mit folgenden Merkmalen:
   ein kräftiger Magnet (M) sorgt für ein gleichförmiges statisches magnetisches Feld und ist an beiden Enden offen, um einen Untersuchungsraum zu bestimmen, in welchem ein menschliches Wesen angeordnet werden kann;
   eine Hochfrequenzspule umgibt den Untersuchungsraum;
   eine Empfangsspule umgibt den Untersuchungsraum und erstes ferromagnetisches Material umgibt den Magneten, die Hochfrequenzspule und die Empfangsspule, um das magnetische Feld abzuschirmen;
   gekennzeichnet durch folgende Merkmale:
   ein im wesentlichen kontinuierlicher zylindrischer Mantel (16) besteht aus zweitem ferromagnetischem Material und weist auf:
   —eine wesentlich größere Länge als die Länge des Magneten (M),
   —eine genügende Wandstärke, um das äußere Streufeld radial auswärts von dem Mantel (16) auf weniger als einen vorbestimmten harmlosen Wert zu bringen, und
   —einen wesentlich größeren Radius als der Durchmesser des Magneten und in der Größenordnung eines Stockwerks, der einem Raum mit einer Decke (11), Seitenwandungen (12, 13) und einem Boden (14) enthält,
   wobei das zweite ferromagnetische Material an einer Stelle angeordnet ist, an der die Permeabilität im wesentlichen auf einem Maximum für ein aufgebrachtes Feld ist, um so den Radius und die Wandstärke zu bestimmen.

2. NMR-System nach Anspruch 1, dadurch gekennzeichnet, daß der vorbestimmte Wert kleiner als $8 \times 10^{-4}$ Tesla (8 Gauss) ist.

3. NMR-System nach Anspruch 1 oder 2, dadurch gekennzeichnet, daß der Mantel (16) aus vergütetem kaltgewalztem Stahl besteht.

4. NMR-System nach einem der Ansprüche 1 bis 3, dadurch gekennzeichnet, daß der Raum (11 bis 14) einen nichtmagnetischen Bodenteil (19) hat, der innerhalb des Mantels und außerhalb des Magneten (M) angeordnet ist.

5. NMR-System nach Anspruch 4, dadurch gekennzeichnet, daß der Raum (11 bis 14) eine Grube (15) im Boden (14) aufweist und daß der Bodenteil (19) in einer Ebene mit dem Raumboden (14) ist.

6. NMR-System nach einem der Ansprüche 1 bis 5, dadurch gekennzeichnet, daß die Konzentrizität des Mantels (16) und des Magneten (M) innerhalb 5 cm liegt und daß die Winkelausrichtung des Zylinders und des Magneten innerhalb von 3° liegt.

7. NMR-System nach einem der Ansprüche 1 bis 6, dadurch gekennzeichnet, daß die Hochfrequenz- und die Empfangsspulen konzentrisch innerhalb 0,5 cm sind.

8. NMR-System nach einem der Ansprüche 1 bis 7, dadurch gekennzeichnet, daß noch ein nichtmagnetischer Träger vorgesehen ist, der axial in und aus den Magneten (M) bewegbar ist, um die zu untersuchende Person zu stützen.

9. NMR-System nach einem der Ansprüche 1 bis 8, dadurch gekennzeichnet, daß der Mantel (16) und der Magnet (M) konzentrisch innerhalb von 0,5 cm sind.

**Revendications**

1. Système d'imagerie par résonance magnétique nucléaire comprenant:

un aimant solénoïde à haut champ (M) procurant un champ magnétique statique uniforme et ayant les deux extrémités ouvertes pour définir une ouverture d'examen dans laquelle un sujet humain peut être placé, une bobine HF entourant l'ouverture d'examen, une bobine réceptrice entourant l'ouverture d'examen et un premier matériau ferromagnétique entourant l'aimant, les bobines HF et réceptrice pour blinder le champ magnétique,

caractérisé en ce que ledit système comprend en outre une enveloppe cylindrique sensiblement continue (16) constituée d'un second matériau ferromagnétique et ayant une longueur sensiblement supérieure à la longueur de l'aimant (M),

—une épaisseur de paroi suffisante pour amener le champ de dispersion radialement vers l'extérieur externe à l'enveloppe (16) à moins d'une valeur prédéterminée inofffensive et

—un rayon sensiblement supérieur au diamètre de l'aimant et de l'ordre des dimensions d'un étage contenant une pièce qui comporte un plafond (11), des murs latéraux (12, 13) et un plancher (14), ledit second matériau ferromagnétique étant placé au point où la perméabilité est sensiblement à un maximum pour le champ imposé de façon à définir ledit rayon et ladite épaisseur de paroi.

2. Système RMN selon la revendication 1, dans lequel la valeur prédéterminée est inférieure à $8 \times 10^{-4}$ Teslas (8 gauss).

3. Système RMN selon la revendication 1 ou 2, dans lequel ladite enveloppe (16) est constituée d'acier laminé à froid et adouci par recuit.

4. Système RMN selon l'une quelconque des revendications 1 à 3, dans lequel ladite pièce (11 à 14) comporte une partie de plancher non magnétique (19) qui est disposée à l'intérieur de ladite enveloppe (16) et extérieurement audit aimant (M).

5. Système RMN selon la revendication 4, dans lequel ladite pièce (11 à 14) comporte un puits (15) dans son plancher (14) et dans lequel ladite partie de plancher (19) est co-planaire avec le plancher de pièce (14).

6. Système RMN selon l'une quelconque des revendications 1 à 5, dans lequel la concentricité de l'enveloppe (16) et de l'aimant (M) est compris dans 5 cm et dans lequel la co-angularité du cylindre et de l'aimant est compris dans 3 degrés.

7. Système RMN selon l'une quelconque des revendications 1 à 6, dans lequel les bobines HF et réceptrices sont concentriques à l'intérieur de 0,5 cm.

8. Système RMN selon l'une quelconque des revendications 1 à 7, comprenant en outre un support non magnétique déplaçable axialement dans et hors de l'aimant (M) pour supporter un sujet devant être examiné.

9. Système RMN selon l'une quelconque des revendications 1 à 8, dans lequel ladite enveloppe (16) et ledit aimant (M) sont concentriques à l'intérieur de 0,5 cm.

FIG. 1

FIG.2